# EUROPEAN PATENT APPLICATION

(11) **EP 1 986 048 A1**
(43) Date of publication of application: **29.10.2008**
(21) Application number: 08004961.2
(22) Date of filing: 17.03.2008
(51) Int. Cl.: G03B 19/00, H01L 23/02, H01L 31/02, H04N 5/225

(54) **Ultra thin image sensing chip package**

(30) Priority: 27.04.2007 TW 96115115
(71) Applicant: Biar, Jin-Chyuan, Hsinchu City 300 (TW); Huang, Chih-Kung, Hsinchu City 300 (TW)
(72) Inventor: Biar, Jin-Chyuan, Hsinchu City 300 (TW); Huang, Chih-Kung, Hsinchu City 300 (TW)
(74) Representative: Becker Kurig Straus

(57) **Abstract**

An ultra thin image sensing chip package (10) includes an image sensing chip (12) and a flexible and optically transparent film (14). The chip (12) has an image sensor (18) and a plurality of electrical conductive pads (20). The flexible and optically transparent film (14) includes a transparent window (26), and a pattern of conductors (30) formed on a surface thereof and around the transparent window. The film (14) wraps the chip (12) in such a way that the transparent window (26) corresponds to the image sensor (18) of the chip, a sealed space (60) is formed between the transparent window (26) and the image sensor(18), one end (32) of each of the conductors (30) of the film (14) bonds to each of the electrical conductive pads (20) of the chip (12), and the other end (34) of each of the conductors (30) of the film (14) is opened so as to electrically connect with other electrical elements.

## Description

### BACKGROUND OF THE INVENTION

### 1. Field of the Invention

This invention relates generally to image sensing chip packages, more particularly, to an ultra thin image sensing chip package.

### 2. Description of the Related Art

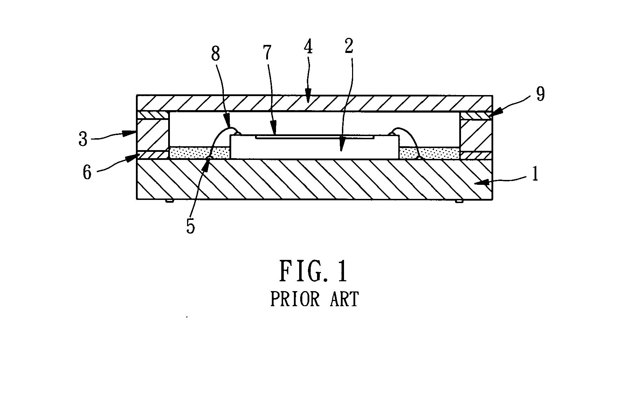

The conventional image sensing chip package, as shown in FIG.1, generally has a substrate 1, an image sensing chip 2, a frame 3 and a light transparent glass 4. Several electrical conductive pads 5 are formed on the upper surface of the substrate 1. The frame 3 is adhered to the substrate 1 using a first glue layer 6. The image sensing chip 2 is mounted to the substrate 1 and has an image sensor 7. The image sensing chip 2 uses metal wires 8 to connect electrical conductive pads 5 by means of wire bonding, thereby achieving electric connection between the image sensing chip 2 and the substrate 1. The light transparent glass 4 seals and covers on the substrate 1 using a second glue layer 9.

As the capabilities of image sensing products continue to expand, while the demand for smaller and more lightweight products expands, a need continues for image sensing packages that are relatively thin and lightweight compared to existing packages. However, the elements just introduced contribute to the thickness and weight of the prior art package so that it is too bulky and heavy to match the nowadays need.

Thus, in nowadays, there is desired an improved image sensing chip package which is relatively thin and lightweight compared to existing packages.

### SUMMARY OF THE INVENTION

The present invention is directed to an improved image sensing chip package. In accordance with the present invention, an ultra thin and lightweight chip package is provided.

The package includes an image sensing chip and a flexible and optically transparent film wrapping the chip. The chip comprises an image sensor disposed on a circuit side thereof that includes a plurality of electrical conductive pads.

The flexible and optically transparent film, being made of plastic materials, such as PE PVC or PC, includes an inner surface, an outer surface, a transparent window, and a pattern of conductors formed on the inner surface and around the transparent window. Each of the conductors has an inner end near edges of the transparent window and an outer end for connecting with other electrical elements.

The film wraps the chip in such a way that the inner surface thereof faces the circuit side of the chip, the transparent window thereof corresponds to the image sensor of the chip, a glue layer is disposed on an area around the transparent window and the image sensor so as to form a sealed space between the transparent window and the image sensor, the inner end of each of the conductors of the film bonds to each of the electrical conductive pads of the chip, and the outer end of each of the conductors of the film is opened so as to electrically connect with other electrical elements.

### BRIEF DESCRIPTION OF THE DRAWINGS

The various objects and advantages of the present invention will be more readily understood from the following detailed description when read in conjunction with the appended drawing, in which:
FIG. 1 is a cross sectional view showing a conventional image sensor package;
FIG. 2 is a schematic perspective view of an image sensing package according to a first preferred embodiment of the present invention;
FIG. 3 is a schematic perspective view of an image sensing chip of the image sensing package shown in FIG. 2;
FIG. 4 is a plan view of a flexible and optically transparent film of the image sensing package shown in FIG. 2;
FIG. 5 is a partly schematic perspective view of the image sensing package shown in FIG. 2;
FIG. 6 is a cross-sectional view taken along line 6-6 of FIG. 2;
FIG. 7 is a cross-sectional view taken along line 7-7 of FIG. 2;
FIG. 8 is a cross-sectional view of an image sensing package according to a second preferred embodiment of the present invention; and
FIG. 9 is a cross-sectional view of an image sensing package according to a third preferred embodiment of the present invention.

### DETAILED DESCRIPTION OF THE INVENTION

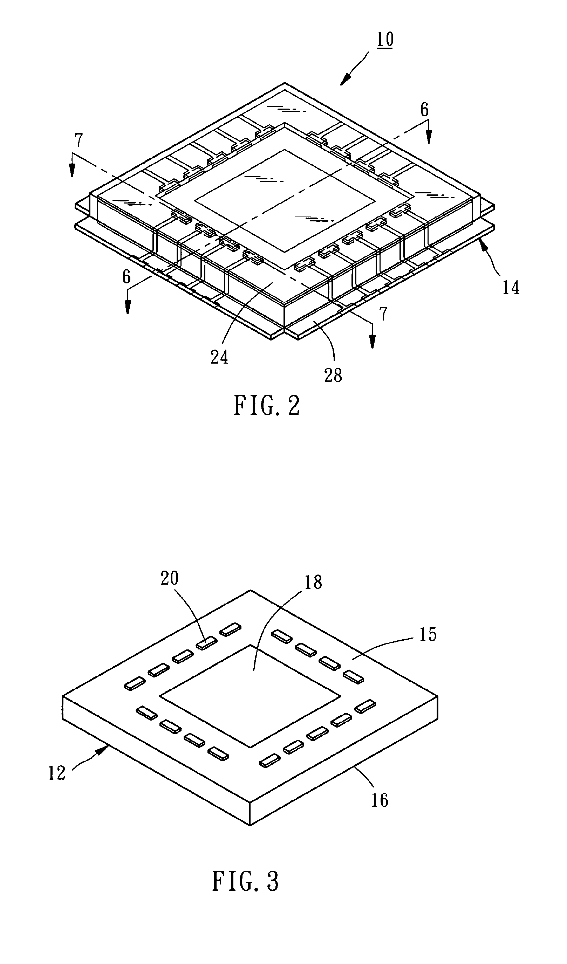

Referring firstly to FIGS. 2 to 7, an ultra thin image sensing chip package 10 according to a first preferred embodiment of the present invention comprises an image sensing chip 12 and a flexible and optically transparent film 14 wrapping chip 12.

The image sensing chip 12, as shown in FIG.3, includes a circuit side 15 and a back side 16. An image sensor 18 is disposed on the centre area of circuit side 15. A plurality of electrical conductive pads 20 are formed on the edges of circuit side 15.

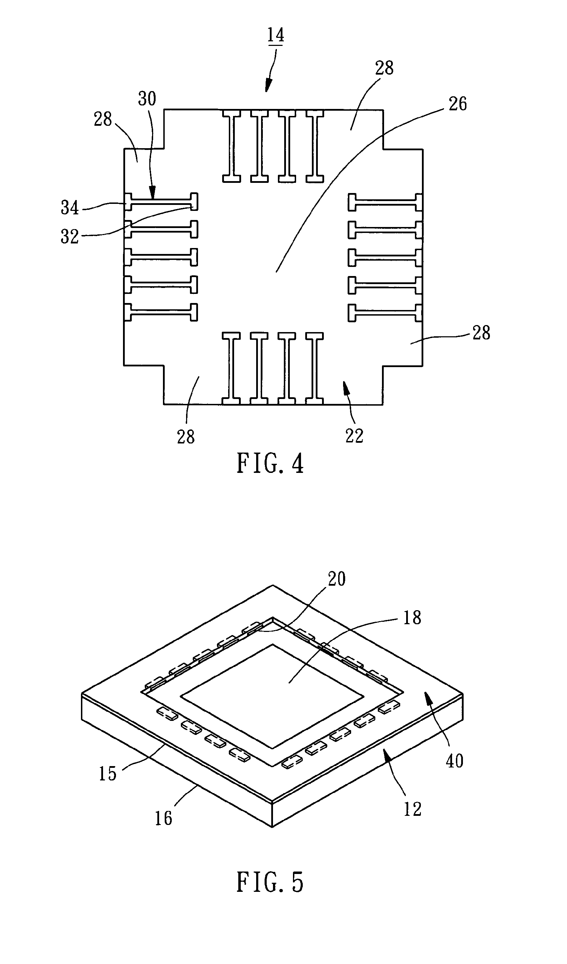

The flexible and optically transparent film 14 is made of plastic materials, such as PE, PVC, PC or any other suitable films. The film 14 in this embodiment, as shown in FIG.4, is square-shaped and includes an inner surface 22, an outer surface 24, a transparent window 26, four foldable sides 28, and a pattern of conductors 30 formed on the inner surface 22. Each of conductors 30 has an inner end 32 near the edges of transparent window 26 and an outer end 34 extending outwardly from inner end 32.

A glue layer 40 is disposed on an area around image sensor 18 of chip 12, as shown in FIG.5, so as to form a sealed space 60 when chip 12 is wrapped by film 14. In this embodiment, glue layer 40 is an anisotropic conductive glue.

When packaging, glue layer 40 is firstly adhered to chip 12 in such a way that it covers the area around image sensor 18 as well as each of electrical conductive pads 20, as shown in FIG. 5, and then film 14 wraps chip 12 in such a way that the inner surface 22 thereof faces circuit side 15 of chip 12, transparent window 26 thereof corresponds to image sensor 18, inner end 32 of each of conductors 30 respectively corresponds to each of electrical conductive pads 20, each foldable side 28 is outwardly folded so that outer end 34 of each of conductors 30 is exposed to outside to connect with other electrical elements.

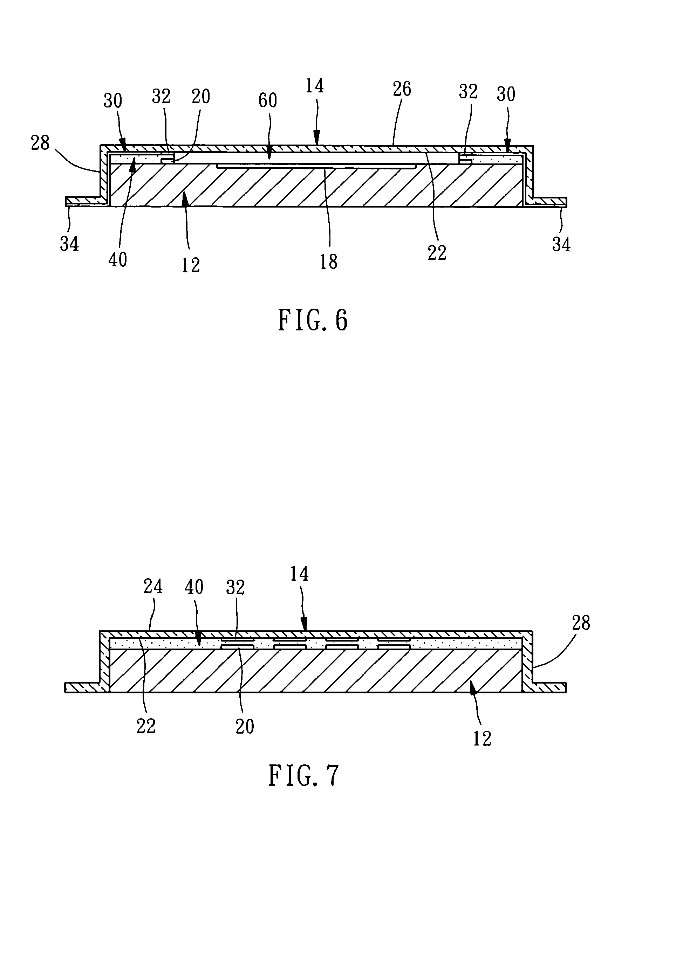

After the wrapping process, film 14, glue layer 40 and chip 12 are heated and pressed together for a period of time. Due to the feature of anisotropic conductive glue, inner end 32 of each of conductors 30 can electrically contact with each of electrical conductive pads 20 but without creating short circuits between these contacts. And in the same time, sealed space 60 between transparent window 26 and image sensor 18, as shown in FIG.7, is established by glue layer 40.

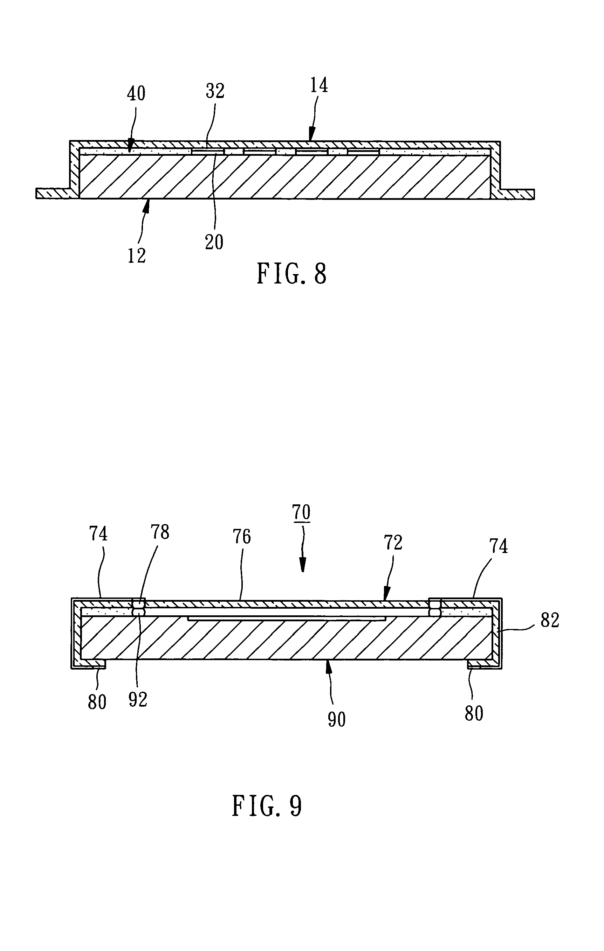

Referring secondly to FIG.8, it is a sectional view illustrating an image sensing chip package according to a second embodiment of the invention, wherein elements of which are common with those of image sensing chip package 10 as shown in the FIG. 2. The difference between them is that each of electrical conductive pads 20 of chip 12 is directly bonded to inner end 32 of each of conductors 30 of film 14.

Referring lastly to FIG.9, it is a sectional view illustrating an image sensing chip package 70 according to a third embodiment of the invention. The difference between image sensing package 70 and image sensing package 10 is that the former has a flexible and optically transparent film 72 with a pattern of conductors 74 formed on an outer surface 76 thereof. Each of conductors 74 has an inner end 78 and an outer end 80. Inner end 78 of each of conductors 74 pierces through film 72 so as to bond to each of electrical conductive pads 92 of chip 90. Film 72 also has four foldable side 82, but each of which is respectively inwardly folded so that outer end 80 of each of conductors 74 is exposed to outside to connect with other electrical elements.

As described above, for having the flexible and optically transparent film substituting for the substrate, frame and light transparent glass of the prior art package, the image sensing chip package provided by the present invention can be thinner and lighter than any existing packages.

## Claims

1. An ultra thin image sensing chip package (10) comprising an image sensing chip (12) including a circuit side (15) and a back side (16), an image sensor (18) disposed on said circuit side (15), and a plurality of electrical conductive pads (20) formed around said image sensor (18);
the ultra thin image sensing chip package being **characterized in that** it further comprises:
a flexible and optically transparent film (14) including an inner surface (22), an outer surface (24), a transparent window (26), and a pattern of conductors (30) formed on said inner surface (22), each of said conductors (30) having an inner end (32) near the edges of said transparent window (26) and an outer end (34) extending outwardly from said inner end (32), and
said film (14) wrapping said chip (12) in such a way that said inner surface (22) of said film (14) faces said circuit side (15) of said chip (12), said transparent window (26) corresponds to said image sensor (18), a sealed space (60) is formed between said transparent window (26) and said image sensor(18), said inner end (32) of each of said conductors (30) of said film (14) bonds to each of said electrical conductive pads (20) of said chip (12), and said outer end (34) of each of said conductors (30) of said film (14) is opened so as to connect with other electrical elements.

2. The image sensing package of claim 1, **characterized in that** a glue layer (40) disposes on an area around said image sensor (18) of said chip (12) so as to form said sealed space (60).

3. The image sensing package of claim 2, **characterized in that** said glue layer (40) is an anisotropic conductive glue.

4. The image sensing package of claim 3, **characterized in that** said anisotropic conductive glue layer (40) is adhered to said image sensing chip (12) in such a way that it covers the area around said image sensor (18) of said chip (12) as well as the electrical conductive pads (20).

5. An ultra thin image sensing package (70) comprising an image sensing chip (90) including a circuit side and a back side, an image sensor disposed on said circuit side, a plurality of electrical conductive pads (92) formed around said image sensor; the ultra thin image sensing package being **characterized in that** it further comprises:
a flexible and optically transparent film (72) including an inner surface, an outer surface (76), a transparent window, and a pattern of conductors (74) formed on said outer surface (76), each of said conductors (74) having an inner end (78) near the edges of said transparent window and an outer end (80) extending outwardly from said inner end (78), and
said film (72) wrapping said chip in such a way that said inner surface of said film faces said circuit side of said chip (90), said transparent window corresponds to said image sensor, a sealed space is formed between said transparent window and said image sensor, said inner end (78) of each of said conductors (74) of said film (72) bonds to each of electrical conductive pads (92) of said chip (90), and said outer end (80) of each of said conductors (74) of said film (72) is opened so as to connect with other electrical elements.

6. The image sensor package of claim 5, **characterized in that** said sealed space is formed by a glue layer which is disposed on an area around said image sensor of said chip.

7. The image sensor package of claim 6, **characterized in that** a glue layer disposes on an area around said image sensor of said chip so as to form said sealed space.

8. The image sensor package of claim 7, **characterized in that** said anisotropic conductive glue layer is adhered to said image sensing chip in such a way that it covers the area around said image sensor of said chip as well as the electrical conductive pads.
